# EUROPEAN PATENT APPLICATION

(11) **EP 4 709 082 A1**
(43) Date of publication of application: **11.03.2026**
(21) Application number: 25187123.2
(22) Date of filing: 03.07.2025
(51) Int. Cl.: H10D 30/01, H10D 30/00, H10D 64/01, H10D 84/01, H10D 84/83, B82Y 10/00

(54) **SELF-ALIGNED GATE CUT WITH HYBRID ARCHITECTURE**

(30) Priority: 09.09.2024 US 202418828223
(71) Applicant: INTEL Corporation, Santa Clara, CA 95054 (US)
(72) Inventor: Hafez, Walid M., Portland, OR 97229 (US); Subramanian, Sairam, Portland, OR 97229 (US)
(74) Representative: Samson & Partner Patentanwälte mbB

(57) **Abstract**

Techniques are provided herein to form semiconductor devices that include one or more self-aligned gate cuts having a hybrid architecture between adjacent devices. In an example, a semiconductor device includes a gate structure around or otherwise on a semiconductor region (also referred to as a channel region). The gate structure may be interrupted between two transistors with a gate cut that extends through at least an entire thickness of the gate structure and includes dielectric material. The gate cut includes a hybrid design that is formed in two parts. A first part of the gate cut is formed prior to any gate patterning and is self-aligned between adjacent fins of semiconductor material. A second part of the gate cut is formed over the first part of the gate cut and is integrated with spacer structures formed on the sidewalls of a sacrificial gate that extends over the adjacent fins.

## Description

### BACKGROUND

As integrated circuits continue to scale downward in size, a number of challenges arise. For instance, reducing the size of memory and logic cells is becoming increasingly more difficult, as is reducing device spacing at the device layer. As transistors are packed more densely, the formation of certain device structures used to isolate adjacent transistors becomes challenging. Accordingly, there remain a number of non-trivial challenges with respect to forming semiconductor devices.

### BRIEF DESCRIPTION OF THE DRAWINGS

Figures 1A and 1B are cross-sectional and plan views, respectively, of some semiconductor devices that have hybrid self-aligned gate cuts between the devices, in accordance with an embodiment of the present disclosure.
Figures 2A and 2B are cross-sectional and plan views that illustrate a first stage in an example process for forming semiconductor devices that have hybrid self-aligned gate cuts between the devices, in accordance with some embodiments of the present disclosure.
Figures 3A and 3B are cross-sectional and plan views that illustrate another stage in the example process for forming semiconductor devices that have hybrid self-aligned gate cuts between the devices, in accordance with some embodiments of the present disclosure.
Figures 4A and 4B are cross-sectional and plan views that illustrate another stage in the example process for forming semiconductor devices that have hybrid self-aligned gate cuts between the devices, in accordance with some embodiments of the present disclosure.
Figures 5A and 5B are cross-sectional and plan views that illustrate another stage in the example process for forming semiconductor devices that have hybrid self-aligned gate cuts between the devices, in accordance with some embodiments of the present disclosure.

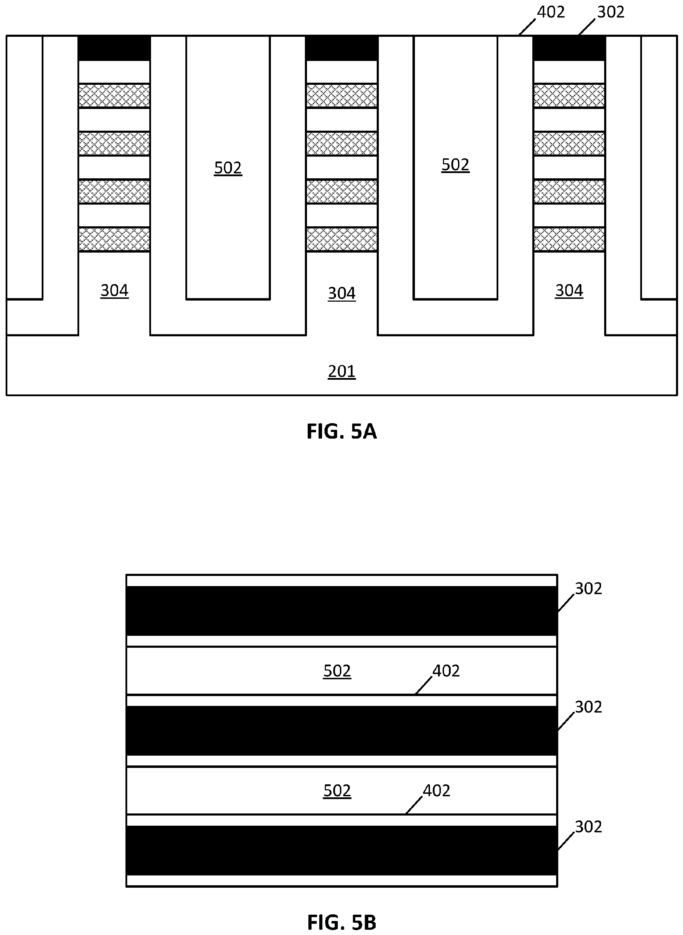

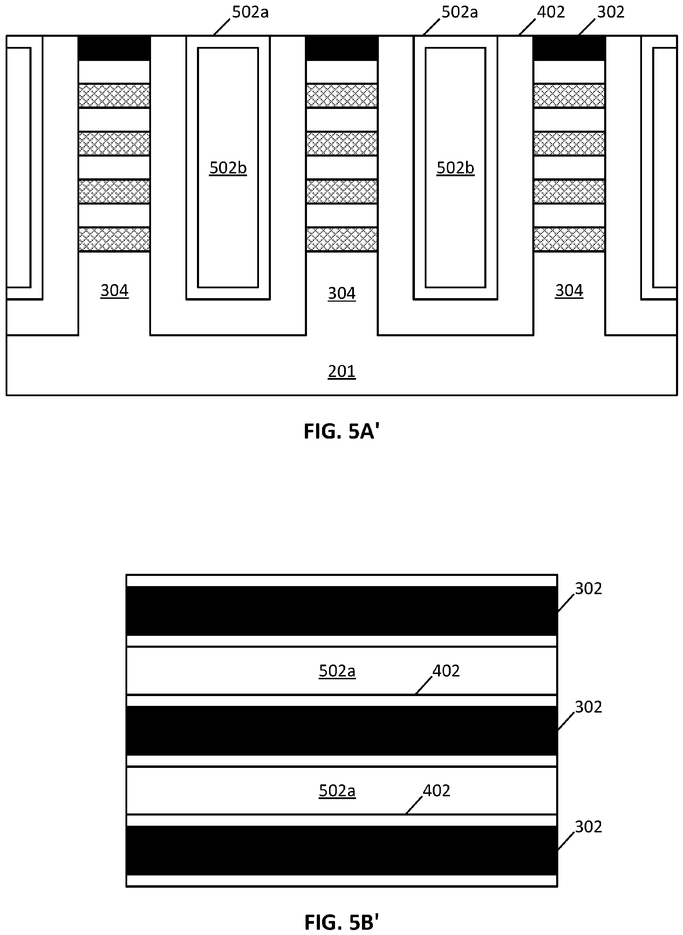

Figures 5A' and 5B' are cross-sectional and plan views that illustrate another stage in the example process for forming semiconductor devices that have hybrid self-aligned gate cuts between the devices, in accordance with some other embodiments of the present disclosure.

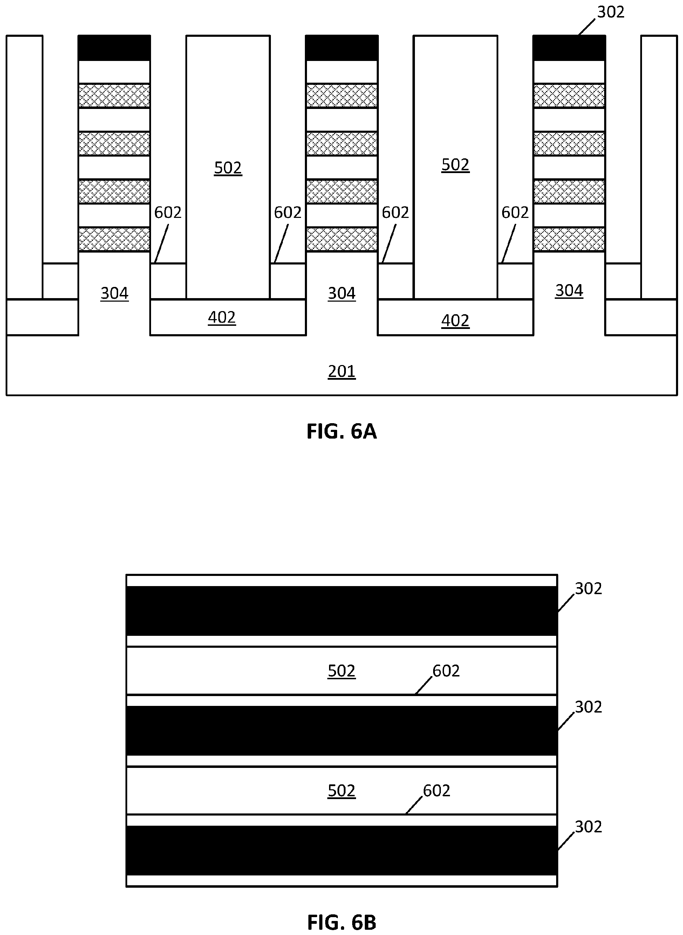

Figures 6A and 6B are cross-sectional and plan views that illustrate another stage in the example process for forming semiconductor devices that have hybrid self-aligned gate cuts between the devices, in accordance with some embodiments of the present disclosure.

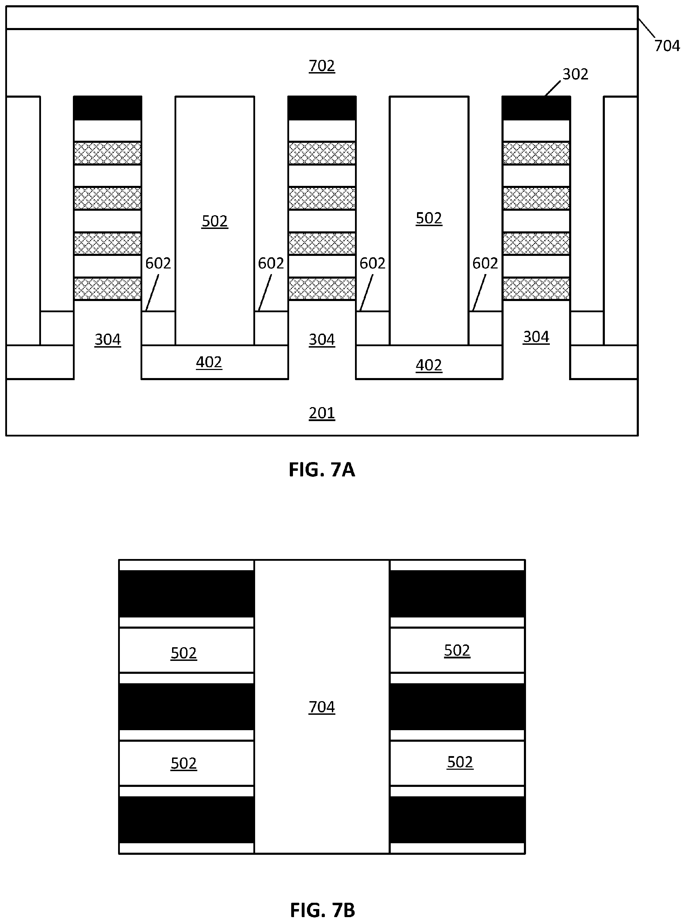

Figures 7A and 7B are cross-sectional and plan views that illustrate another stage in the example process for forming semiconductor devices that have hybrid self-aligned gate cuts between the devices, in accordance with some embodiments of the present disclosure.

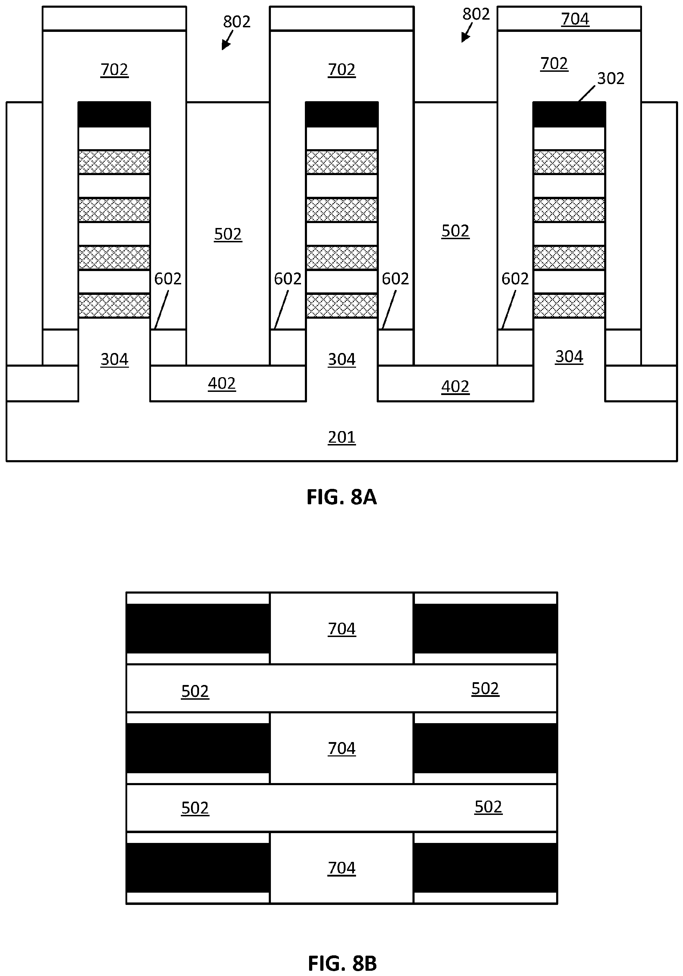

Figures 8A and 8B are cross-sectional and plan views that illustrate another stage in the example process for forming semiconductor devices that have hybrid self-aligned gate cuts between the devices, in accordance with some embodiments of the present disclosure.

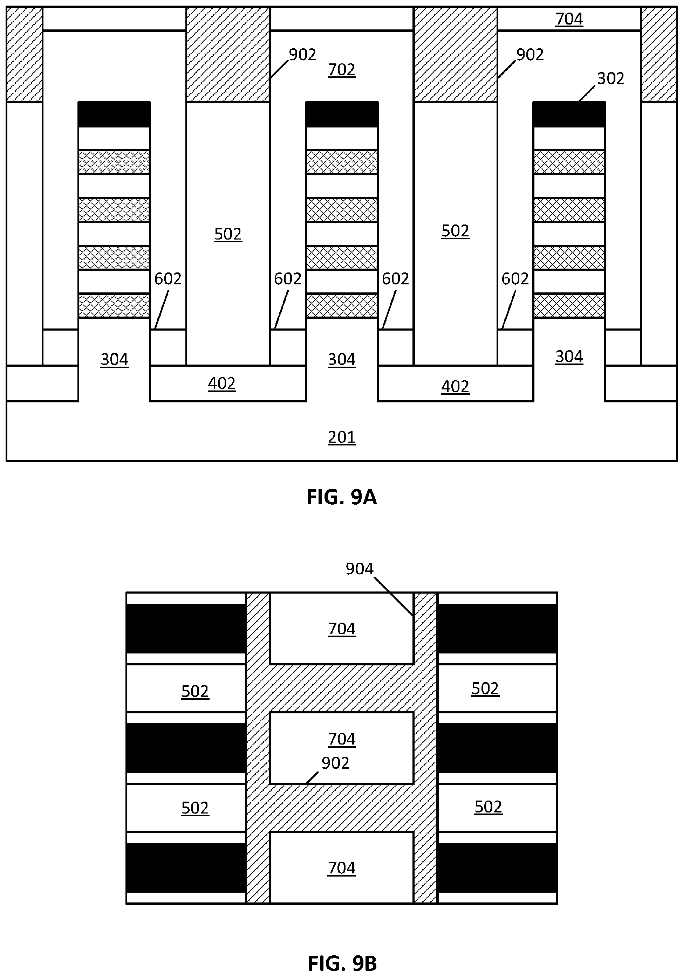

Figures 9A and 9B are cross-sectional and plan views that illustrate another stage in the example process for forming semiconductor devices that have hybrid self-aligned gate cuts between the devices, in accordance with some embodiments of the present disclosure.

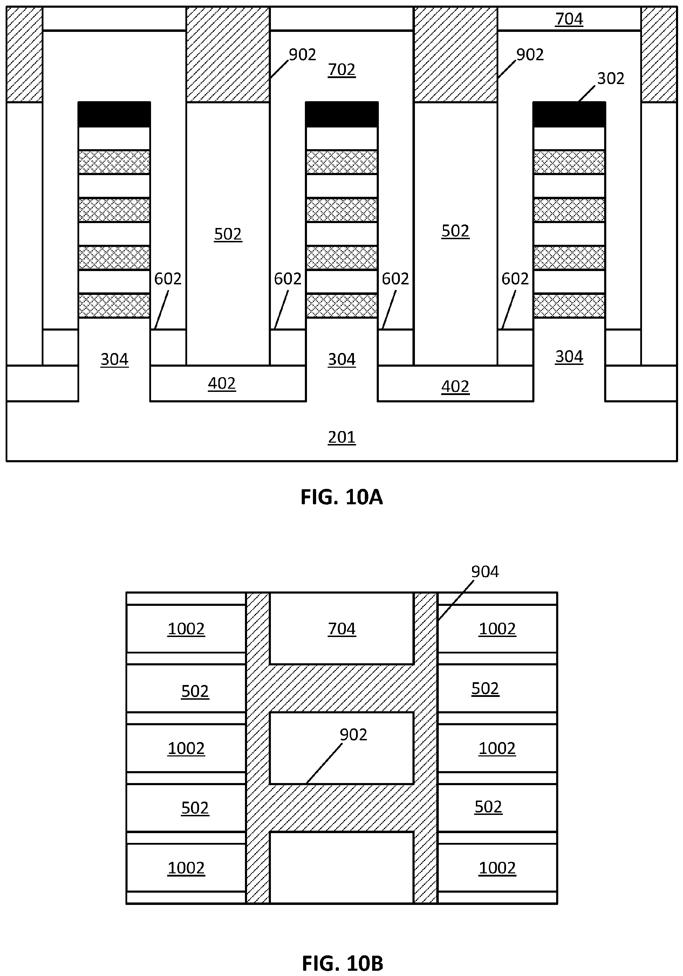

Figures 10A and 10B are cross-sectional and plan views that illustrate another stage in the example process for forming semiconductor devices that have hybrid self-aligned gate cuts between the devices, in accordance with some embodiments of the present disclosure.

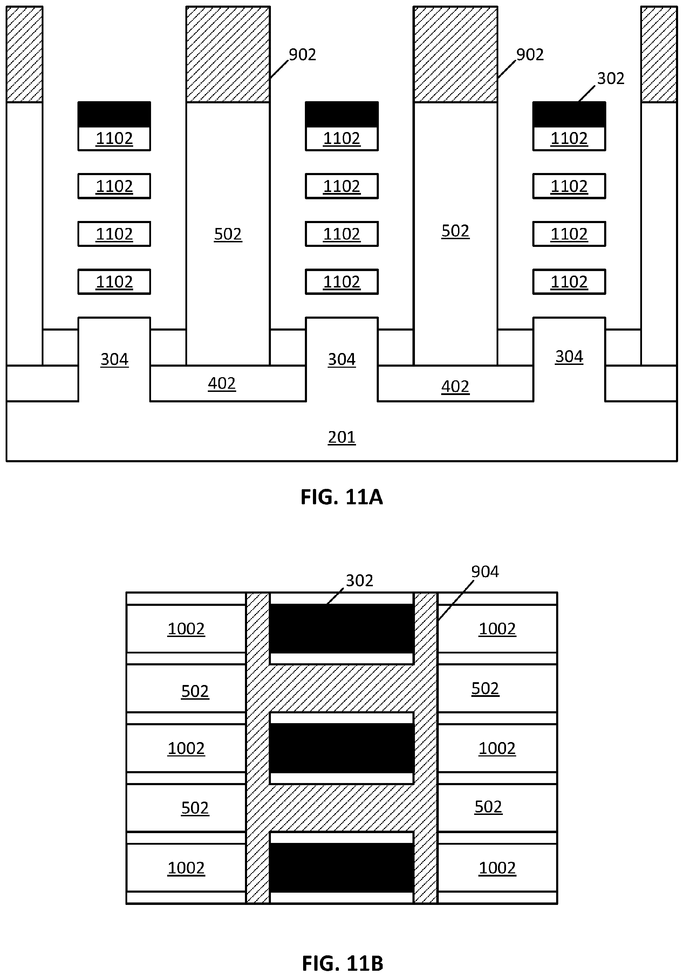

Figures 11A and 11B are cross-sectional and plan views that illustrate another stage in the example process for forming semiconductor devices that have hybrid self-aligned gate cuts between the devices, in accordance with some embodiments of the present disclosure.

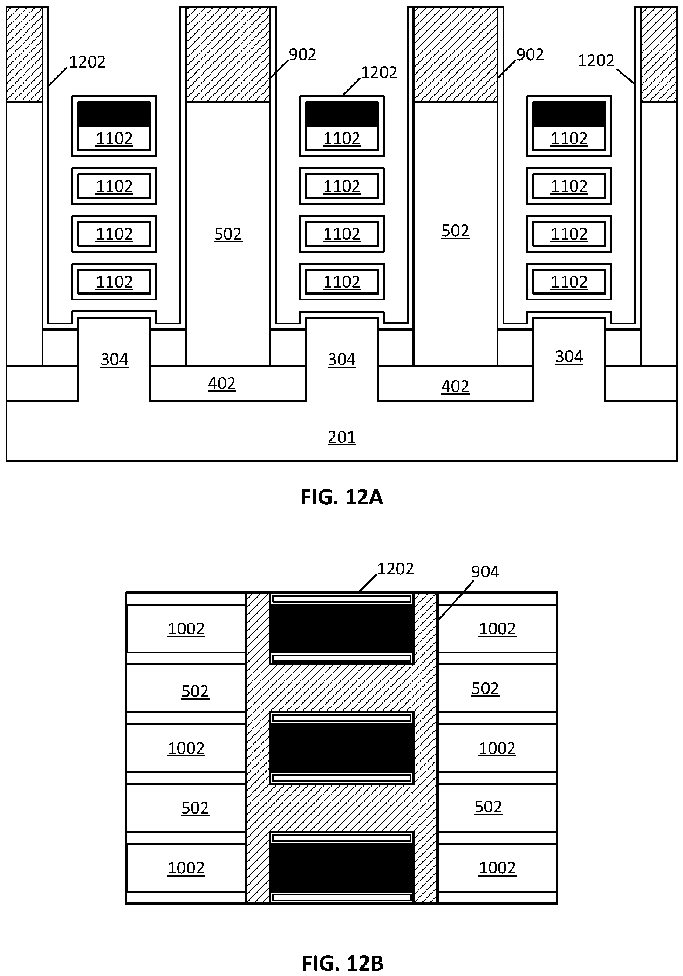

Figures 12A and 12B are cross-sectional and plan views that illustrate another stage in the example process for forming semiconductor devices that have hybrid self-aligned gate cuts between the devices, in accordance with some embodiments of the present disclosure.

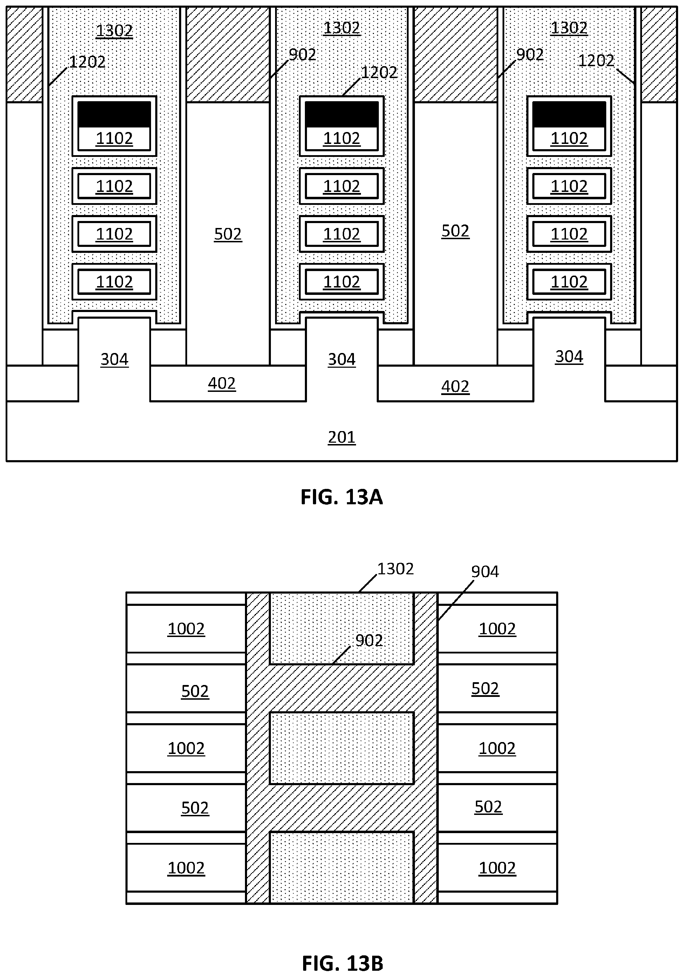

Figures 13A and 13B are cross-sectional and plan views that illustrate another stage in the example process for forming semiconductor devices that have hybrid self-aligned gate cuts between the devices, in accordance with some embodiments of the present disclosure.

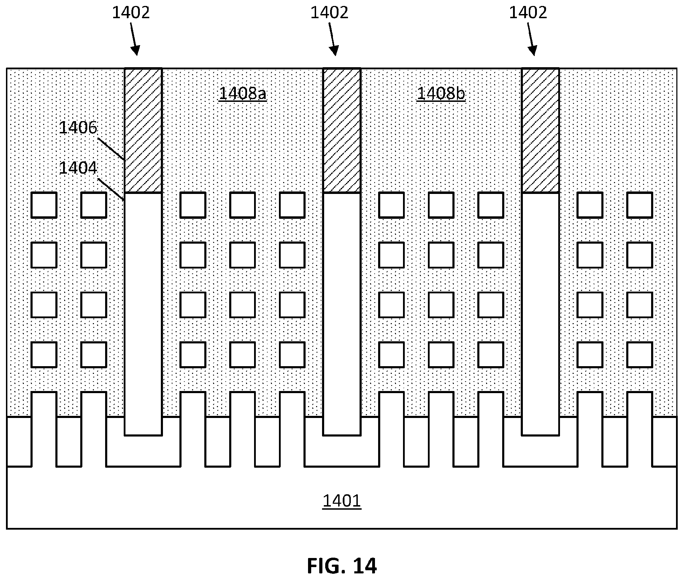

Figure 14 is a cross-sectional view that illustrates hybrid self-aligned gate cuts between devices that are spaced further apart compared to other devices, in accordance with some embodiments of the present disclosure.

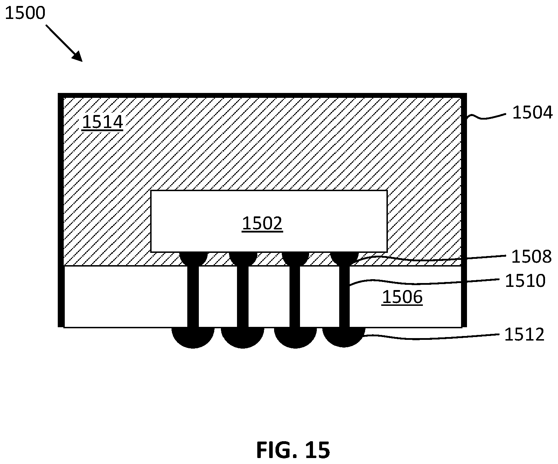

Figure 15 illustrates a cross-sectional view of a chip package containing one or more semiconductor dies, in accordance with some embodiments of the present disclosure.

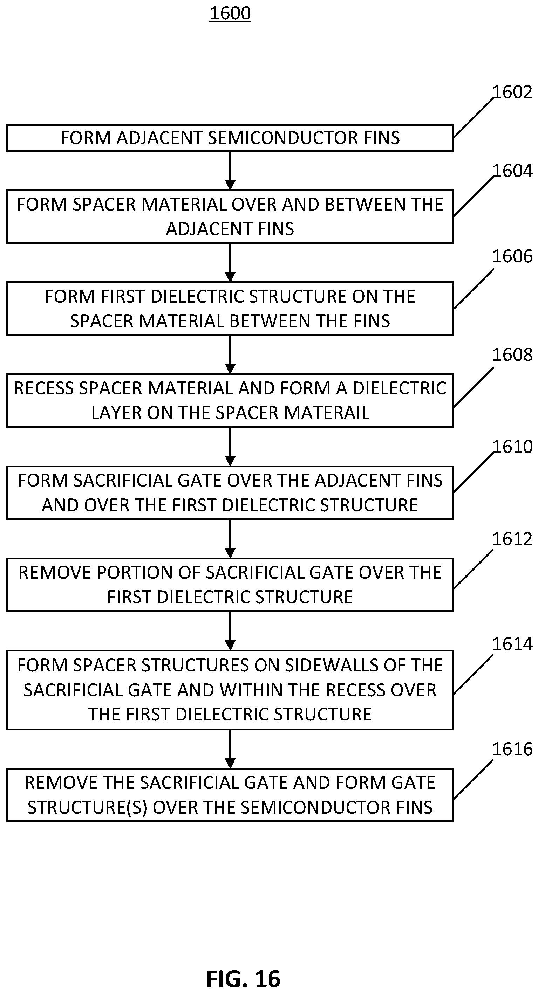

Figure 16 is a flowchart of a fabrication process for semiconductor devices that have hybrid self-aligned gate cuts between the devices, in accordance with an embodiment of the present disclosure.

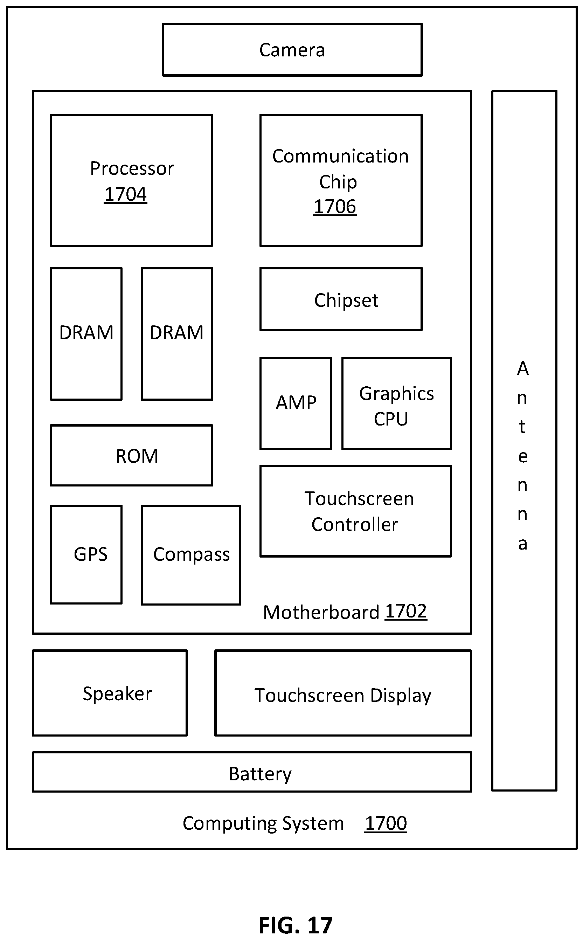

Figure 17 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form semiconductor devices that include one or more self-aligned gate cuts having a hybrid architecture between adjacent devices. The techniques can be used in any number of integrated circuit applications and are particularly useful with respect to device layer transistors, such as finFETs or gate-all-around transistors (e.g., ribbonFETs and nanowire FETs) or forksheet transistors (e.g., nanosheet FETs). In an example, a semiconductor device includes a gate structure around or otherwise on a semiconductor region (also referred to as a channel region). The semiconductor region can be, for example, a fin of semiconductor material that extends from a source region to a drain region, or one or more nanowires, nanoribbons, or nanosheets of semiconductor material that extend from a source region to a drain region. The gate structure includes a gate dielectric (e.g., high-k gate dielectric material) and a gate electrode (e.g., conductive material such as workfunction material and/or gate fill metal). The gate structure may be interrupted, for example, between two transistors with a gate cut that extends through at least an entire thickness of the gate structure and includes dielectric material to electrically isolate the portions of the gate structure on either side of the gate cut. According to some embodiments, the gate cut includes a hybrid design that is formed in two parts. A first part of the gate cut is formed prior to any gate patterning and is self-aligned between adjacent fins of semiconductor material. A second part of the gate cut is formed over the first part of the gate cut and is integrated with spacer structures formed on the sidewalls of a sacrificial gate that extends over the adjacent fins. Numerous configurations and variations will be apparent in light of this disclosure.

### General Overview

As previously noted above, there remain a number of non-trivial challenges with respect to integrated circuit fabrication. In more detail, as devices become smaller and more densely packed, many structures become more challenging to fabricate as critical dimensions (CD) of the structures push the limits of current fabrication technology. Example structures like gate cuts are used in integrated circuit design to isolate gate structures from one another. Such gate cuts may be formed in various ways, but there are drawbacks to existing techniques for forming gate cuts. Gate cuts are often high-aspect ratio structures, which requires deep etches to be made through one or more materials between adjacent devices. However, it is difficult to maintain a sufficient degree of selectivity for these deep etches while ensuring that the etched trenches reach all the way through the entire thickness of the adjacent gate structures.

Thus, and in accordance with an embodiment of the present disclosure, techniques are provided herein to form hybrid self-aligned gate cuts between devices (e.g., at a cell boundary). The gate cuts may have a hybrid structure that is formed in two sections. A first section may be self-aligned between adjacent fins prior to any gate patterning and a second section may be formed on the first section after the formation of a sacrificial gate over the fins. In this way, the etch used to form the second section of the gate cut only needs to land on the top surface of the first section of the gate cut, rather than land on the bottom of the gate trench. The gate cuts may be self-aligned between any types of transistor devices, such as finFETs, gate-all-around (GAA) devices, and forksheet devices. In the case of forksheet devices, the self-aligned gate cuts may be formed at a different time than the dielectric spine between the nanosheet devices. According to some embodiments, the first section of the gate cut may include a dielectric liner and a dielectric fill on the dielectric liner. The dielectric fill may includes a low-k dielectric material (e.g., a dielectric having a dielectric constant of about 4.5 or less) while the dielectric liner may include a high-k dielectric material (e.g., a dielectric having a dielectric constant of about 5.5 or more). According to some embodiments, the second section of the gate cut may include the same dielectric material as used for spacer structures on the edges of the gate trench. For example, the second section of the gate cut may include silicon nitride, silicon oxynitride, or silicon oxycarbide. In some embodiments, the second section of the gate cut is seamless integrated with the spacer structures.

According to an embodiment, an integrated circuit includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region, and a second gate structure extending in the second direction over the second semiconductor region, a first dielectric structure between the first and second semiconductor devices and separating the first gate structure from the second gate structure along the second direction, and a second dielectric structure on the top surface of the first dielectric structure, wherein the second dielectric structure also separates the first gate structure from the second gate structure along the second direction. The first dielectric structure extends along a third direction through a portion of an entire height of the first or second gate structures, and the second dielectric structure extends along the third direction through a remaining portion of the entire height of the first or second gate structures.

According to another embodiment, an integrated circuit includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending in the second direction over the second semiconductor region, spacer structures on sidewalls of the first and second gate structures and extending along the second direction with the first and second gate structures, a first dielectric structure separating the first gate structure from the second gate structure along the second direction, and a second dielectric structure on the top surface of the first dielectric structure. The second dielectric structure also separates the first gate structure from the second gate structure along the second direction. The second dielectric structure and the spacer structures are a continuous body of material such that there is no seam between the second dielectric structure and the spacer structures.

According to another embodiment, a method of forming an integrated circuit includes: forming at least two adjacent fins comprising semiconductor material, the fins extending above a substrate and each extending parallel to one another in a first direction; forming a spacer material over and between the at least two adjacent fins; forming a first dielectric structure on the spacer material between the at least two adjacent fins; recessing the spacer material between the at least two adjacent fins; forming a dielectric fill between the at least two adjacent fins and adjacent to the first dielectric structure; recessing the dielectric fill between the at least two adjacent fins; forming a sacrificial gate extending over the semiconductor material of the at least two adjacent fins and over the first dielectric structure in a second direction different from the first direction; forming a recess through the sacrificial gate over the first dielectric structure; forming spacer structures on sidewalls of the sacrificial gate and within the recess over the first dielectric structure, such that the spacer structures within the recess form a second dielectric structure; removing the sacrificial gate; and forming a gate structure on the semiconductor material of each of the adjacent fins.

The techniques can be used with any type of non-planar transistors, including finFETs (sometimes called tri-gate transistors), nanowire and nanoribbon transistors (sometimes called gate-all-around transistors), or forksheet transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-last process (sometimes called a replacement metal gate, or RMG, process). Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may be used to detect the presence of a gate cut between devices that is substantially equidistant (e.g., within 1-2 nm) between the adjacent semiconductor devices. Furthermore, the tools may also be used to show that the gate cut includes two distinct sections, with a first section being between the adjacent devices and a second section on the first section. The second section of the gate cut may be seamlessly integrated with the adjacent spacer structures. Numerous configurations and variations will be apparent in light of this disclosure.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

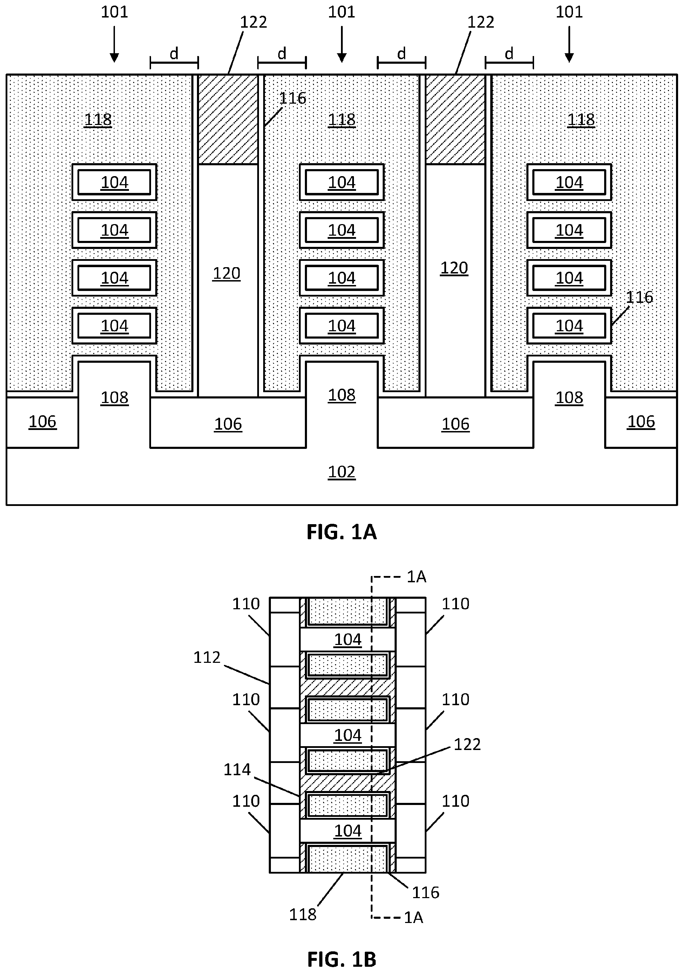

Figure 1A is a cross-sectional view taken across several semiconductor devices 101, according to an embodiment of the present disclosure. Figure 1B is a top-down cross-section view of the semiconductor devices 101, and Figure 1A illustrates the cross-section taken across the dashed line 1A-1A depicted in Figure 1B. It should be noted that some of the material layers have been omitted in the top-down view of Figure 1B in order to see the structures underneath. Each of semiconductor devices 101 may be non-planar metal oxide semiconductor (MOS) transistors, such as tri-gate (e.g., finFET), gate-all-around (GAA), or forksheet transistors, although other transistor topologies and types could also benefit from the gate cut techniques and structures provided herein. The illustrated example embodiments herein use the GAA structure. Semiconductor devices 101 represent a portion of an integrated circuit that may contain any number of similar semiconductor devices.

As can be seen, semiconductor devices 101 are formed over a substrate 102. Any number of semiconductor devices can be formed over substrate 102, but three are shown here as an example. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some example embodiments, a lower portion of (or all of) substrate 102 is removed and replaced with one or more backside interconnect layers to form backside signal and power routing.

Each of semiconductor devices 101 includes one or more nanoribbons 104 that extend parallel to one another along a direction between a source region and a drain region (e.g., a first direction into and out of the page in the cross-section view of Figure 1A). Nanoribbons 104 are one example of semiconductor regions or semiconductor bodies that extend between source and drain regions. The term nanoribbon may also encompass other similar shapes such as nanowires or nanosheets. The semiconductor material of nanoribbons 104 may be formed from substrate 102. In some embodiments, semiconductor devices 101 may each include semiconductor regions in the shape of fins that can be, for example, native to substrate 102 (formed from the substrate itself), such as silicon fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of the illustrated nanoribbons 104 during a gate forming process where one type of the alternating layers is selectively etched away so as to liberate the other type of alternating layers within the channel region, so that a gate-all-around (GAA) or forksheet process can then be carried out. Again, the alternating layers can be blanket deposited and then etched into fins or deposited into fin-shaped trenches, according to some examples.

As can further be seen, adjacent semiconductor devices are separated by a dielectric layer 106 that may include silicon dioxide. Dielectric layer 106 provides shallow trench isolation (STI) between any adjacent semiconductor devices, and adjacent subfin regions 108. Dielectric layer 106 can be any suitable dielectric material, such as silicon dioxide, aluminum oxide, or silicon oxycarbonitride.

Semiconductor devices 101 each include a subfin region 108, in this example. According to some embodiments, subfin region 108 comprises the same semiconductor material as substrate 102 and is adjacent to dielectric layer 106. According to some embodiments, nanoribbons 104 (or other semiconductor bodies) extend between a source and a drain region in the first direction to provide an active region for a transistor (e.g., the semiconductor region beneath the gate). The source and drain regions are not shown in the cross-section of Figure 1A, but are seen in the top-down view of Figure 1B where nanoribbons 104 of each semiconductor device 101 extend between source or drain regions 110. Figure 1B also illustrates a dielectric fill 112 between source or drain regions 110 of a given source/drain trench extending along a second direction (e.g., across the page in Figure 1A). Dielectric fill 112 may include any suitable dielectric material, such as silicon dioxide. According to some embodiments, spacer structures 114 extend around the ends of nanoribbons 104 and along sidewalls of the gate structures. Spacer structures 114 may include a dielectric material, such as silicon nitride, and may be deposited in a conformal fashion or other suitable deposition process and be etched to a desired thickness (e.g., 2 nm to 10 nm).

According to some embodiments, the source and drain regions 110 are epitaxial regions that are provided using an etch-and-replace process. Any semiconductor materials suitable for source and drain regions can be used (e.g., group IV and group III-V semiconductor materials). The source and drain regions 110 may include multiple layers such as liners and capping layers to improve contact resistance. In any such cases, the composition and doping of the source and drain regions 110 may be the same or different, depending on the polarity of the transistors. In an example, silicon doped with phosphorous may be used for n-type source or drain regions while silicon germanium doped with boron may be used for p-type source or drain regions. Any number of source and drain configurations and materials can be used.

According to some embodiments, each semiconductor device 101 includes a gate structure extending over nanoribbons 104 along the second direction across the page of Figure 1A. The second direction may be orthogonal to the first direction. Each gate structure includes a respective gate dielectric 116 and a gate electrode 118. Gate dielectric 116 represents any number of dielectric layers present between nanoribbons 104 and gate electrode 118. Gate dielectric 116 may also be present on the surfaces of other structures within the gate trench, such as on portions of subfin region 108. Gate dielectric 116 may include any suitable gate dielectric material(s). In some embodiments, gate dielectric 116 includes a layer of native oxide material (e.g., silicon dioxide) on the nanoribbons or other semiconductor regions making up the channel region of the devices, and a layer of high-K dielectric material (e.g., hafnium oxide) on the native oxide.

Gate electrode 118 may represent any number of conductive layers, such as any metal, metal alloy, or doped polysilicon layers. In some embodiments, gate electrode 118 includes one or more workfunction metals around nanoribbons 104. In some embodiments, one or more of semiconductor devices 101 is a p-channel device that includes a workfunction metal having titanium around its nanoribbons 104. In some embodiments, one or more of semiconductor devices 101 is an n-channel device that includes a workfunction metal having tungsten around its nanoribbons 104. Gate electrode 118 may also include a fill metal or other conductive material (e.g., tungsten, ruthenium, molybdenum, cobalt) around the workfunction metals to provide the whole gate electrode structure.

According to some embodiments, adjacent gate structures may be separated along the second direction (e.g., across the page) by a gate cut, which acts like a dielectric barrier or wall between gate structures. The gate cut may include a first dielectric structure 120 and a second dielectric structure 122 on first dielectric structure 120. The gate cut extends vertically (e.g., in a third direction) through at least an entire thickness of the adjacent gate structures on either side of the gate cut. Accordingly, first dielectric structure 120 extends through a first portion of the thickness of the gate structures and second dielectric structure 122 extends through a second portion of the thickness of the gate structures. In some embodiments, first dielectric structure 120 rests on a top surface of dielectric layer 106. According to some embodiments, first dielectric structure 120 includes a dielectric liner along an outer edge of first dielectric structure 120 and a dielectric fill on the dielectric liner. According to some embodiments, the dielectric liner includes a high-k dielectric material, such as silicon nitride, and the dielectric fill includes a medium-k or low-k dielectric material (e.g., a dielectric having a dielectric constant of about 4.5 or less), such as silicon dioxide, porous silicon dioxide, or flowable oxide.

According to some embodiments, second dielectric structure 122 includes a different dielectric material compared to first dielectric structure 120. In some examples, second dielectric structure 122 includes silicon nitride, silicon oxynitride, or silicon oxycarbide. Second dielectric structure 122 may be offset from first dielectric structure 120 along the second direction by up to 1 nm, up to 2 nm, or up to 3 nm. According to some embodiments, second dielectric structure 122 is seamlessly integrated with spacer structures 114 as shown more clearly in the top-down view of Figure 1B. Thus, second dielectric structure 122 and spacer structures 114 may be formed from the same dielectric material deposited at the same time, as will be discussed in more detail herein. In this manner, second dielectric structure 122 and spacer structures 114 may be a monolithic and continuous body of material, such that there is no seam between second dielectric structure 122 and spacer structures 114.

According to some embodiments, the gate cuts are self-aligned within the gate trench between adjacent devices such that a distance (d) between each edge of the gate cut and the corresponding nanoribbons 104 along a common plane is substantially the same (e.g., distance d on one side is within 1 nm of distance d on the other side). The distance (d) may vary depending on the device density, but may generally be between about 5 nm and about 20 nm. It should be noted that any number of devices may be separated using the gate cuts. In the example illustrated in Figures 1A and 1B, the gate cuts separate single devices from one another along the second direction. However, the gate cuts may also be patterned to separate groups of 2, 3, 4, or more devices from other groups of devices. As will be discussed in more detail herein, the gate cuts are formed before the formation of the gate structures, such that gate dielectric 116 extends along the sidewalls of both first dielectric structure 120 and second dielectric structure 122.

### Fabrication Methodology

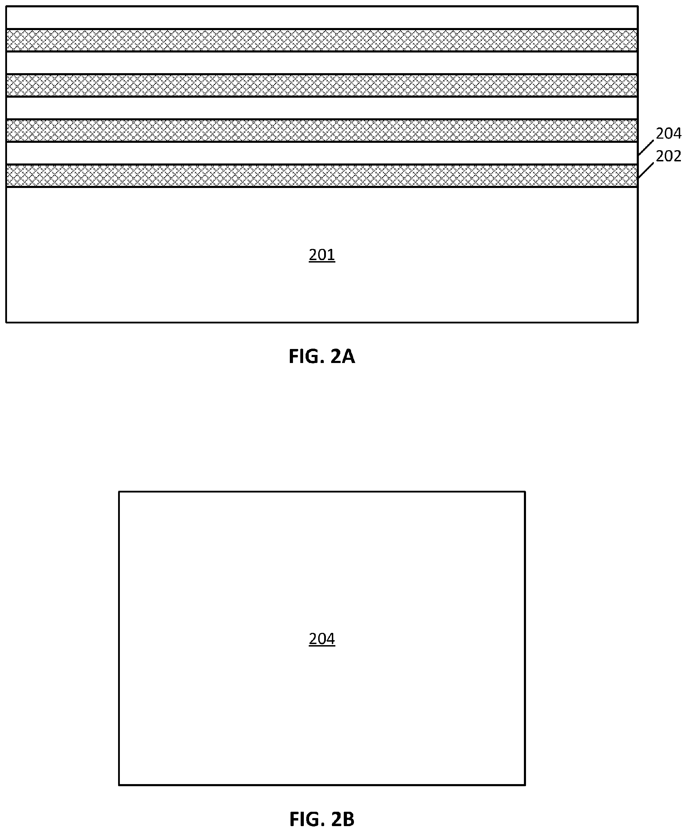

Figures 2A - 13A and 2B - 13B include cross-sectional and plan views, respectively, that collectively illustrate an example process for forming an integrated circuit with semiconductor devices that have hybrid self-aligned gate cuts between the devices, in accordance with an embodiment of the present disclosure. Figures 2A - 13A represent a similar cross-sectional view as that of Figure 1A across a series of semiconductor devices, while Figures 2B - 13B represent the corresponding plan view at each stage of the fabrication. Each set of figures sharing the same letter shows an example structure that results from the process flow up to that point in time, so the depicted structure evolves as the process flow continues, culminating in the structure shown in Figures 13A - 13B, which is similar to the structure shown in Figures 1A and 1B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure. Although the fabrication of two gate cuts are illustrated in the aforementioned figures, it should be understood that any number of similar gate cuts can be fabricated across the integrated circuit using the same processes discussed herein.

Figures 2A and 2B illustrate a cross-sectional view taken through a substrate 201 and a plan view across substrate 201 having a series of material layers formed over the substrate, according to an embodiment of the present disclosure. Alternating material layers may be deposited over substrate 201 including sacrificial layers 202 alternating with semiconductor layers 204. The alternating layers are used to form GAA transistor structures. Any number of alternating semiconductor layers 204 and sacrificial layers 202 may be deposited over substrate 201. The description above for substrate 102 applies equally to substrate 201. The plan view of Figure 2B illustrates the topmost semiconductor layer 204 of the layer stack.

According to some embodiments, sacrificial layers 202 have a different material composition than semiconductor layers 204. In some embodiments, sacrificial layers 202 are silicon germanium (SiGe) while semiconductor layers 204 include a semiconductor material suitable for use as a nanoribbon such as silicon (Si), SiGe, germanium, or III-V materials like indium phosphide (InP) or gallium arsenide (GaAs). In examples where SiGe is used in each of sacrificial layers 202 and in semiconductor layers 204, the germanium concentration is different between sacrificial layers 202 and semiconductor layers 204. For example, sacrificial layers 202 may include a higher germanium content compared to semiconductor layers 204. In some examples, semiconductor layers 204 may be doped with either n-type dopants (to produce a p-channel transistor) or p-type dopants (to produce an n-channel transistor).

While dimensions can vary from one example embodiment to the next, the thickness of each sacrificial layer 202 may be between about 5 nm and about 20 nm. In some embodiments, the thickness of each sacrificial layer 202 is substantially the same (e.g., within 1-2 nm). The thickness of each of semiconductor layers 204 may be about the same as the thickness of each sacrificial layer 202 (e.g., about 5-20 nm). Each of sacrificial layers 202 and semiconductor layers 204 may be deposited using any known or proprietary material deposition technique, such as chemical vapor deposition (CVD), plasma-enhanced chemical vapor deposition (PECVD), physical vapor deposition (PVD), or atomic layer deposition (ALD).

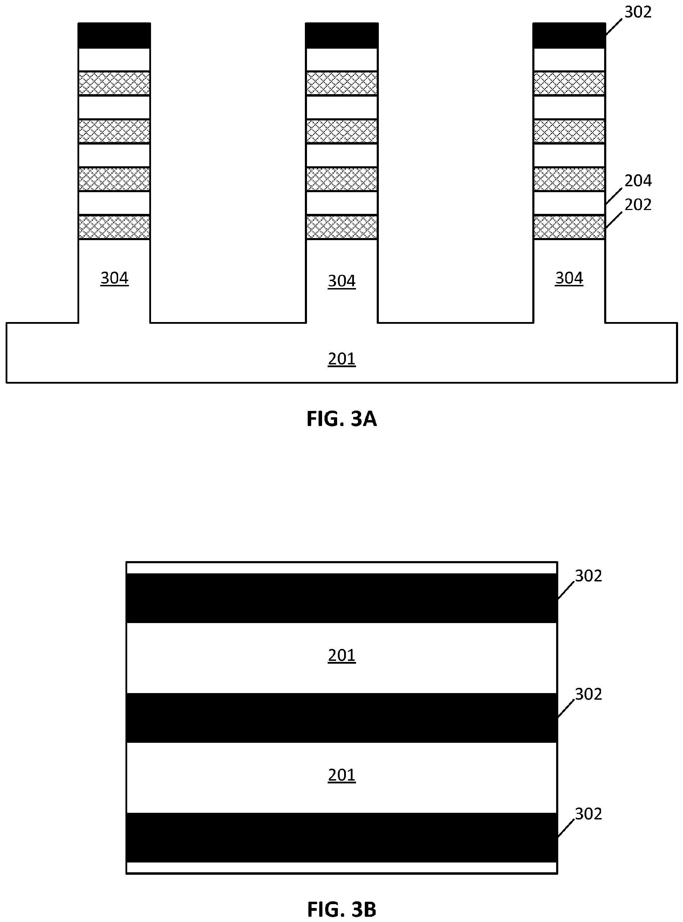

Figures 3A and 3B depict the cross-section and plan views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. The rows of fins extend lengthwise in a first direction (e.g., into and out of the page of Figure 3A). According to some embodiments, an anisotropic etching process through the layer stack continues into at least a portion of substrate 201 yielding subfin regions 304. Subfin regions 304 represent remaining portions of substrate 201 directly beneath the alternating layers of sacrificial layers 202 and semiconductor layers 204, according to some embodiments.

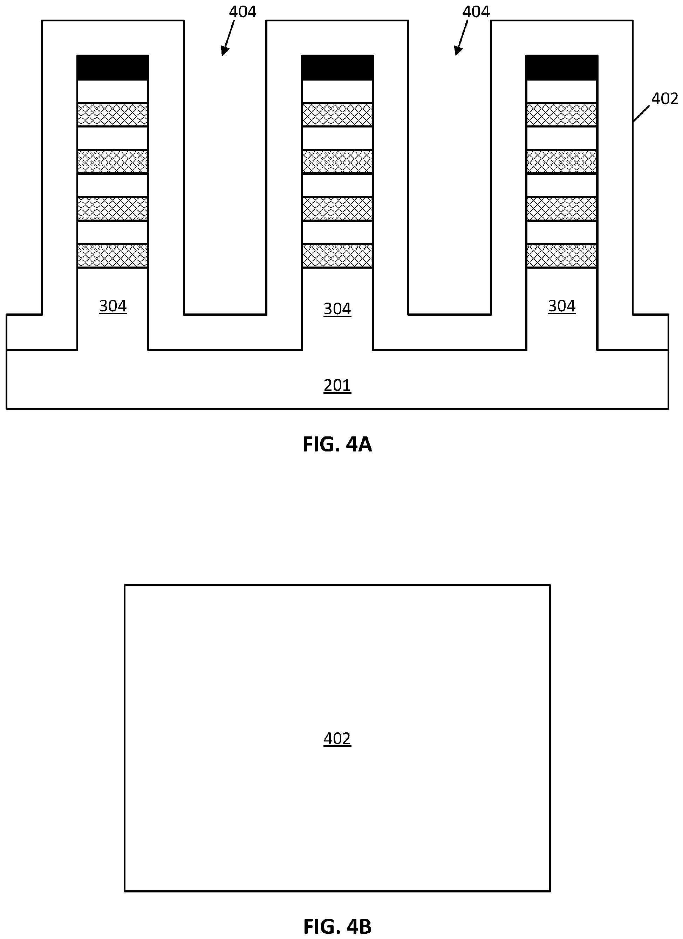

Figures 4A and 4B depict the cross-section and plan views of the structure shown in Figures 3A and 3B, respectively, following the deposition of a spacer material 402, according to some embodiments. Spacer material 402 may be conformally deposited over the fins using, for example, chemical vapor deposition (CVD) or atomic layer deposition (ALD). According to some embodiments, the conformal deposition will leave behind trench-shaped recesses 404 between fins that are spaced far enough apart. If the fins are too close to one another, then the spacer material 402 will substantially fill the space between the fins and no recess will result. In this way, the locations of recesses 404 may be determined based on the spacing between the adjacent fins. According to some embodiments, spacer material 402 includes an oxide-based material, such as silicon dioxide. Spacer material 402 may have a conformal thickness over the fins between about 5 nm and about 30 nm.

Figures 5A and 5B depict the cross-section and plan views of the structure shown in Figures 4A and 4B, respectively, following the formation of a first dielectric structure 502 within recesses 404, according to some embodiments. In the illustrated example, dielectric structure 502 includes a single dielectric material and is polished such that its top surface is substantially coplanar with a top surface of cap layer 302 (or the top surface of the topmost semiconductor layer 204 in examples where cap layer 302 is removed). First dielectric structure 502 may include any suitable dielectric material, such as silicon dioxide, silicon nitride, or silicon oxynitride.

Figures 5A' and 5B' depict the cross-section and plan views of the structure shown in Figures 4A and 4B, respectively, following an alternative formation of first dielectric structure 502 that includes a dielectric liner 502a and a dielectric fill 502b, according to some embodiments. Dielectric liner may include a high-k dielectric material, such as hafnium oxide, and dielectric fill 502b may include a low-k dielectric material, such as silicon dioxide. Other dielectric liners may include silicon nitride or silicon oxynitride. According to some embodiments, dielectric liner 502a is first deposited on the sidewalls and bottom surface of recesses 404 followed by the formation of dielectric fill 502b on dielectric liner 502a within recesses 404. Then, dielectric fill 502b can be recessed and the remaining portion of dielectric liner 502a is formed in the recessed area, such that dielectric liner 502a surrounds dielectric fill 502b. In other words, dielectric liner 502a is present on bottom, side, and top surfaces of dielectric fill 502b.

Figures 6A and 6B depict the cross-section and plan views of the structure shown in Figures 5A and 5B, respectively, following the recessing of spacer material 402 and further formation of dielectric layer 602, according to some embodiments. Spacer material 402 may be recessed using a suitable isotropic etching process. In some examples, spacer material 402 is recessed such that a top surface of spacer material 402 is at least below a top surface of subfin region 304, or at least below a midpoint along the height of subfin region 304. According to some embodiments, another dielectric material is deposited across the structure and subsequently recessed to form dielectric layer 602 around the bottom of first dielectric structure 502. Dielectric layer 602 may be formed to have a top surface that is below a top surface of subfin region 304. Together, spacer material 402 and dielectric layer 602 can act as shallow trench isolation (STI) between adjacent fins. In some examples, dielectric layer 602 is omitted such that spacer material 402 alone acts as STI between adjacent fins. It should be noted that the dielectric materials of each of spacer material 402 and dielectric layer 602 have sufficient etch selectively with the dielectric material of first dielectric structure 502, such that the isotropic etching of both spacer material 402 and dielectric layer 602 does not appreciably etch first dielectric structure 502.

Figures 7A and 7B depict the cross-section and plan views of the structure shown in Figures 6A and 6B, respectively, following the formation of a sacrificial gate 702 beneath a gate masking layer 704 extending across the fins in a second direction different from the first direction, according to some embodiments. Gate masking layer 704 may include any suitable hard mask material, such as carbon hard mask (CHM), and be patterned into strips to form corresponding strips of sacrificial gate 702. Sacrificial gate 702 may extend across the fins in a second direction that is orthogonal to the first direction. According to some embodiments, the sacrificial gate material is formed in parallel strips across the integrated circuit and removed (e.g., using an etching process) in all the areas not protected by gate masking layer 704. Sacrificial gate 702 may be any suitable material that can be selectively removed without damaging the semiconductor material of the fins. In some examples, sacrificial gate 702 includes polysilicon.

Figures 8A and 8B depict the cross-section and plan views of the structure shown in Figures 7A and 7B, respectively, following further patterning of gate masking layer 704 to remove portions of gate masking layer 704 over first dielectric structures 502, according to some embodiments. Gate masking layer 704 may be patterning using suitable lithography techniques to expose portions of the underlying sacrificial gate 702 above first dielectric structures 502. As such, the openings through gate masking layer 704 may have a similar width (e.g., along the second direction) as a width of first dielectric structures 502.

According to some embodiments, an etching process is performed to remove the exposed portions of sacrificial gate 702 not protected by gate masking layer 704 to form openings 802. At least a portion of the top surfaces of first dielectric structure 502 are exposed at the bottom of openings 802.

Figures 9A and 9B depict the cross-section and plan views of the structure shown in Figures 8A and 8B, respectively, following the formation of second dielectric structures 902 on first dielectric structures 502 (e.g., within openings 802) and the formation of spacer structures 904 on the sidewalls of sacrificial gate 702 and gate masking layer 704, according to some embodiments. Both second dielectric structures 902 and spacer structures 904 may be formed from the same material deposited at the same time such that second dielectric structures 902 and spacer structures 904 are seamlessly integrated as shown in Figure 9B. Note how second dielectric structures 902 and spacer structures 904 are a continuous body of material, such that there is no seam between second dielectric structures 902 and spacer structures 904. The dielectric material may be blanket deposited across the structure and etched back to form spacer structures 904 on the sidewalls of any structures extending above substrate 201 and second dielectric structures 902 within openings 802. Spacer structures 904 extend along the sides of sacrificial gate 702 and gate masking layer 704 along the second direction as illustrated in Figure 9B. In some embodiments, spacer structures may also form on the sides of the fins not under sacrificial gate 702 or on sides of first dielectric structure 502. In some examples, second dielectric structures 902 and spacer structures 904 include silicon nitride, silicon oxynitride, or silicon oxycarbide.

Figures 10A and 10B depict the cross-section and plan views of the structure shown in Figures 9A and 9B, respectively, following the removal of any exposed fins and the subsequent formation of source or drain regions 1002 at the ends of the fins, according to some embodiments. The exposed fin portions (e.g., not protected by either sacrificial gate 702 or spacer structures 904) may be removed using any anisotropic etching process, such as reactive ion etching (RIE). The removal of the exposed fin portions creates source or drain trenches that alternate with gate trenches (currently filled with sacrificial gates 702) along the first direction, according to some embodiments.

According to some embodiments, source or drain regions 1002 may be formed from the exposed ends of the fins within the source/drain trench. Source or drain regions 1002 may be formed in the areas that had been previously occupied by the exposed fins adjacent to spacer structures 904. According to some embodiments, source or drain regions 1002 are epitaxially grown from the exposed semiconductor material at the ends of semiconductor layers 204. In some example embodiments, any of source or drain regions 1002 can be NMOS source or drain regions (e.g., epitaxial silicon), or PMOS source or drain regions (e.g., epitaxial SiGe).

According to some embodiments, a dielectric fill is provided within the source/drain trench. In some examples, the dielectric fill occupies a remaining volume within the source/drain trench around and possibly over both source or drain regions 1002 and first dielectric structure 502. The dielectric fill may be any suitable dielectric material, such as silicon dioxide. In some examples, the dielectric fill extends up to and planar with a top surface of spacer structures 904 (e.g., following a polishing procedure). Accordingly, the dielectric fill has not been illustrated in the top-down view of Figure 10B so as to not obscure the features beneath it.

Figures 11A and 11B depict the cross-section and plan views of the structure shown in Figures 10A and 10B, respectively following the removal of gate masking layer 704, sacrificial gate 702, and sacrificial layers 202, according to some embodiments. Once sacrificial gate 702 is removed, the fins that had been beneath sacrificial gate 702 are exposed within the gate trench.

In the example where the fins include alternating semiconductor layers, sacrificial layers 202 are selectively removed to release nanoribbons 1102 that extend between corresponding source or drain regions 1002 along the first direction. Each vertical set of nanoribbons 1102 represents the semiconductor or channel region of a different semiconductor device. It should be understood that nanoribbons 1102 may also be nanowires or nanosheets (e.g., from a forksheet arrangement) or fins (e.g., for a finFET arrangement). Sacrificial gate 702 and sacrificial layers 202 may be removed using the same isotropic etching process or different isotropic etching processes. Also, note that source or drain regions 1002 abut or otherwise contact respective ends of nanoribbons 1102, underneath spacer structures 904, so as to provide a transistor conduction path from the source region to the drain region, when the gate is properly biased. In some examples, cap layer 302 remains on the topmost nanoribbons 1102. In other examples, cap layer 302 is removed at any time earlier in the fabrication process.

Figures 12A and 12B depict the cross-section and plan views of the structure shown in Figures 11A and 11B, respectively, following the formation of a gate dielectric 1202 over any exposed surfaces within the gate trench, according to some embodiments. Gate dielectric 1202 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, gate dielectric 1202 includes a layer of hafnium oxide with a thickness between about 1 nm and about 5 nm. In some embodiments, gate dielectric 1202 may include one or more silicates (e.g., titanium silicate, tungsten silicate, niobium silicate, and silicates of other transition metals). In some cases, gate dielectric 1202 may include a first layer on nanoribbons 1102, and a second layer on the first layer. The first layer can be, for instance, an oxide of the semiconductor material of nanoribbons 1102 (e.g., silicon dioxide) and the second layer can be a high-k dielectric material (e.g., hafnium oxide). More generally, gate dielectric 1202 can include any number of dielectric layers. According to some embodiments, gate dielectric 1202 forms along all surfaces exposed within the gate trench, such as along inner sidewalls of the spacer structures (as seen in Figure 7B) and along the exposed surfaces of subfin regions 304. According to some embodiments, gate dielectric 1202 also forms along the sidewalls of both first dielectric structures 502 and second dielectric structures 902 within the gate trench. Since both first dielectric structures 502 and second dielectric structures 902 were formed prior to the formation of gate dielectric 1202, gate dielectric 1202 may transition seamlessly along the sidewalls across the boundary between first dielectric structures 502 and second dielectric structures 902.

Figures 13A and 13B depict the cross-section and plan views of the structure shown in Figures 12A and 12B, respectively, following the formation of a gate electrode 1302 around nanoribbons 1102 and on gate dielectric 1202 within the gate trench, according to some embodiments. Gate electrode 1302 may include any number of conductive layers. The conductive gate electrode 1302 may be deposited using electroplating, electroless plating, CVD, PECVD, ALD, or PVD, to name a few examples. In some embodiments, gate electrode 1302 includes doped polysilicon, a metal, or a metal alloy. Example suitable metals or metal alloys include aluminum, tungsten, cobalt, molybdenum, ruthenium, titanium, tantalum, copper, and carbides and nitrides thereof. Gate electrode 1302 may include, for instance, a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Following the formation of the gate structure, the entire structure may be polished or planarized such that the top surface of the gate structure (e.g., top surface of gate electrode 1302) is substantially coplanar with the top surface of other semiconductor elements, such as spacer structures 904 that define the gate trench and second dielectric structure 902. Accordingly, the gate cuts made up of first dielectric structure 502 and second dielectric structure 902 separate different gate structures along the second direction.

As discussed above, the techniques described herein may be used to form gate cuts that separate any number of transistors. Figure 14 illustrates an example portion of an integrated circuit having a substrate 1401 with GAA devices separated by gate cuts 1402. In this example, groups of three transistors are separated by gate cuts 1402 made up of first dielectric structure 1404 and second dielectric structure 1406. Accordingly, a first gate structure 1408a may be formed around three devices between corresponding gate cuts 1402 and a second gate structure 1408b may be formed around three other devices between corresponding gate cuts 1402. According to some embodiments, the gate cuts are self-aligned between devices that are further spaced from each other along the first direction. Gate cuts do not form between the closer devices as spacer material 402 would not leave adequate space between the closer devices to from the gate cuts, as referenced above with respect to Figure 4A.

Figure 15 illustrates an example embodiment of a chip package 1500, in accordance with an embodiment of the present disclosure. As can be seen, chip package 1500 includes one or more dies 1502. One or more dies 1502 may include at least one integrated circuit having semiconductor devices, such as any of the semiconductor devices disclosed herein. One or more dies 1502 may include any other circuitry used to interface with other devices formed on the dies, or other devices connected to chip package 1500, in some example configurations.

As can be further seen, chip package 1500 includes a housing 1504 that is bonded to a package substrate 1506. The housing 1504 may be any standard or proprietary housing, and may provide, for example, electromagnetic shielding and environmental protection for the components of chip package 1500. The one or more dies 1502 may be conductively coupled to a package substrate 1506 using connections 1508, which may be implemented with any number of standard or proprietary connection mechanisms, such as solder bumps, ball grid array (BGA), pins, or wire bonds, to name a few examples. Package substrate 1506 may be any standard or proprietary package substrate, but in some cases includes a dielectric material having conductive pathways (e.g., including conductive vias and lines) extending through the dielectric material between the faces of package substrate 1506, or between different locations on each face. In some embodiments, package substrate 1506 may have a thickness less than 1 millimeter (e.g., between 0.1 millimeters and 0.5 millimeters), although any number of package geometries can be used. Additional conductive contacts 1512 may be disposed at an opposite face of package substrate 1506 for conductively contacting, for instance, a printed circuit board (PCB). One or more vias 1510 extend through a thickness of package substrate 1506 to provide conductive pathways between one or more of connections 1508 to one or more of contacts 1512. Vias 1510 are illustrated as single straight columns through package substrate 1506 for ease of illustration, although other configurations can be used (e.g., damascene, dual damascene, through-silicon via, or an interconnect structure that meanders through the thickness of substrate 1506 to contact one or more intermediate locations therein). In still other embodiments, vias 1510 are fabricated by multiple smaller stacked vias, or are staggered at different locations across package substrate 1506. In the illustrated embodiment, contacts 1512 are solder balls (e.g., for bumpbased connections or a ball grid array arrangement), but any suitable package bonding mechanism may be used (e.g., pins in a pin grid array arrangement or lands in a land grid array arrangement). In some embodiments, a solder resist is disposed between contacts 1512, to inhibit shorting.

In some embodiments, a mold material 1514 may be disposed around the one or more dies 1502 included within housing 1504 (e.g., between dies 1502 and package substrate 1506 as an underfill material, as well as between dies 1502 and housing 1504 as an overfill material). Although the dimensions and qualities of the mold material 1514 can vary from one embodiment to the next, in some embodiments, a thickness of mold material 1514 is less than 1 millimeter. Example materials that may be used for mold material 1514 include epoxy mold materials, as suitable. In some cases, the mold material 1514 is thermally conductive, in addition to being electrically insulating.

### Methodology

Figure 16 is a flow chart of a method 1600 for forming at least a portion of an integrated circuit, according to an embodiment. Various operations of method 1600 may be illustrated in Figures 2A - 13A and 2B - 13B. However, the correlation of the various operations of method 1600 to the specific components illustrated in the aforementioned figures is not intended to imply any structural and/or use limitations. Rather, the aforementioned figures provide one example embodiment of method 1600. Other operations may be performed before, during, or after any of the operations of method 1600. For example, method 1600 does not explicitly describe all processes that are performed to form common transistor structures. Some of the operations of method 1600 may be performed in a different order than the illustrated order.

Method 1600 begins with operation 1602 where any number of parallel semiconductor fins, including at least two adjacent fins, are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. The alternating layers can be blanket deposited and then etched into fins, or deposited into fin-shaped trenches. The fins may also include a cap structure over each fin that is used to define the locations of the fins during, for example, an RIE process. The cap structure may be a dielectric material, such as silicon nitride. In some embodiments, the anisotropic etching process that forms the fins also etches into a portion of the substrate.

Method 1600 continues with operation 1604 where a spacer material is formed over and between the fins. According to some embodiments, the spacer material is conformally deposited over the fins such that the spacer material has substantially the same thickness on the top and sidewall surfaces of the fins. The spacer material may be conformally deposited over the fins using, for example, CVD, PECVD, or ALD. According to some embodiments, the conformal deposition will leave behind a trench-shaped recess between the adjacent fins if they are spaced far enough apart. If the fins are too close to one another, then the spacer material will substantially fill the space between the fins and no recess will result. The spacer material may include an oxide-based material, such as silicon dioxide and may have a conformal thickness over the fins between about 5 nm and about 30 nm.

Method 1600 continues with operation 1606 where a first dielectric structure is formed within the trench-shaped recess between the adjacent fins. In some examples, the first dielectric structure includes a single dielectric material, such as silicon dioxide, silicon nitride, or silicon oxynitride. In some examples, the first dielectric structure includes a dielectric liner and a dielectric fill on the dielectric liner. The dielectric liner may include a high-k dielectric material, such as hafnium oxide, and the dielectric fill may include a low-k dielectric material, such as silicon dioxide. Other dielectric liners may include silicon nitride or silicon oxynitride. According to some embodiments, a first portion of the dielectric liner is formed on the sidewalls and bottom of the trench-shaped recess, followed by formation of the dielectric fill on the dielectric liner, and then a second portion of the dielectric liner is formed over the top surface of the dielectric fill. In other words, the dielectric liner is present on bottom, side, and top surfaces of the dielectric fill.

Method 1600 continues with operation 1608 where the spacer material is recessed. The spacer material may be recessed using a suitable isotropic etching process. In some examples, the spacer material is recessed such that a top surface of the spacer material is at least below a topmost surface of the substrate. According to some embodiments, another dielectric material is deposited across the structure and subsequently recessed to form a dielectric layer around the bottom of the first dielectric structure and on a top surface of the recessed spacer material. Together, the spacer material and the dielectric layer can act as STI between the adjacent fins. In some examples, only the spacer material is provided to act as STI between the adjacent fins.

Method 1600 continues with operation 1610 where a sacrificial gate is formed over the adjacent fins. The sacrificial gate may be patterned using a gate masking layer in a strip that runs orthogonally over the fins (many gate masking layers and corresponding sacrificial gates may be formed parallel to one another (e.g., forming a cross-hatch pattern with the fins). The sacrificial gate also crosses over the first dielectric structure extending parallel to and between the adjacent fins. The gate masking layer may be any suitable hard mask material, such as CHM or silicon nitride. The sacrificial gate may be formed from any suitable material that can be selectively removed at a later time without damaging the semiconductor material of the fins. In one example, the sacrificial gate includes polysilicon.

Method 1600 continues with operation 1612 where a portion of the sacrificial gate is removed over the first dielectric structure. The gate masking layer may be patterned using any suitable lithography techniques to expose the portion of the sacrificial gate over the first dielectric structure. The exposed portion may then be etched to form an opening through a portion of the sacrificial gate that reveals at least a portion of the top surface of the first dielectric structure.

Method 1600 continues with operation 1614 where dielectric material is deposited to form spacer structures on the sidewalls of the sacrificial gate and to form a second dielectric structure on the first dielectric structure within the opening through the portion of the sacrificial gate. The dielectric material may be deposited and then etched back such that the spacer structures remain mostly only on sidewalls of any exposed structures and the second dielectric structure remains within the opening. According to some embodiments, the dielectric material of the spacer structures and the second dielectric structure may be any suitable dielectric material, such as silicon nitride, silicon oxynitride, or silicon oxycarbide. Since the spacer structures and second dielectric structure are formed together, there may be no visible seam between the structures where they contact each other.

Method 1600 continues with operation 1616 where the sacrificial gate is removed and gate structures are formed over the adjacent fins (and separated by the combined structure of the first dielectric structure and the second dielectric structure. The sacrificial gate may be removed using an isotropic etching process that selectively removes all of the material from the sacrificial gate, thus exposing the various fins between the set of spacer structures. In the example case where GAA transistors are used, any sacrificial layers within the exposed fins between the spacer structures may also be removed to release nanoribbons, nanosheets, or nanowires of semiconductor material.

The gate structure(s) formed over the adjacent fins include a gate dielectric and a gate electrode. The gate dielectric may be formed over the exposed semiconductor regions between the spacer structures. The gate dielectric may include any number of dielectric layers deposited using a CVD process, such as ALD. One or more annealing processes may also be used to affect the elemental composition of the gate dielectric. The gate electrode may include any number of conductive layers deposited using electroplating, electroless plating, CVD, PECVD, ALD, or PVD, to name a few examples. In some embodiments, the gate electrode includes a metal fill material along with one or more workfunction layers, resistance-reducing layers, and/or barrier layers. The workfunction layers can include, for example, p-type workfunction materials (e.g., titanium nitride) for PMOS gates, or n-type workfunction materials (e.g., titanium aluminum carbide) for NMOS gates. Following the formation of the gate structure, the entire structure may be polished or planarized such that the top surface of the gate structure (e.g., top surface of the gate electrode) is substantially coplanar with the top surface of other semiconductor elements, such as the spacer structures that define the gate trench and/or the top surface of the second dielectric structure.

### Example System

FIG. 17 is an example computing system implemented with one or more of the integrated circuit structures as disclosed herein, in accordance with some embodiments of the present disclosure. As can be seen, the computing system 1700 houses a motherboard 1702. The motherboard 1702 may include a number of components, including, but not limited to, a processor 1704 and at least one communication chip 1706, each of which can be physically and electrically coupled to the motherboard 1702, or otherwise integrated therein. As will be appreciated, the motherboard 1702 may be, for example, any printed circuit board (PCB), whether a main board, a daughterboard mounted on a main board, or the only board of system 1700, etc.

Depending on its applications, computing system 1700 may include one or more other components that may or may not be physically and electrically coupled to the motherboard 1702. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1700 may include one or more integrated circuit structures or devices configured in accordance with an example embodiment, such as a module including an integrated circuit on a substrate, the substrate having semiconductor devices with one or more gate cuts that are fashioned as described herein. In some embodiments, multiple functions can be integrated into one or more chips (e.g., for instance, note that the communication chip 1706 can be part of or otherwise integrated into the processor 1704).

The communication chip 1706 enables wireless communications for the transfer of data to and from the computing system 1700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1706 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1700 may include a plurality of communication chips 1706. For instance, a first communication chip 1706 may be dedicated to shorter range wireless communications such as Wi-Fi and Bluetooth and a second communication chip 1706 may be dedicated to longer range wireless communications such as GPS, EDGE, GPRS, CDMA, WiMAX, LTE, Ev-DO, and others.

The processor 1704 of the computing system 1700 includes an integrated circuit die packaged within the processor 1704. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1706 also may include an integrated circuit die packaged within the communication chip 1706. In accordance with some such example embodiments, the integrated circuit die of the communication chip includes one or more semiconductor devices as variously described herein. As will be appreciated in light of this disclosure, note that multi-standard wireless capability may be integrated directly into the processor 1704 (e.g., where functionality of any chips 1706 is integrated into processor 1704, rather than having separate communication chips). Further note that processor 1704 may be a chip set having such wireless capability. In short, any number of processor 1704 and/or communication chips 1706 can be used. Likewise, any one chip or chip set can have multiple functions integrated therein.

In various implementations, the computing system 1700 may be a laptop, a netbook, a notebook, a smartphone, a tablet, a personal digital assistant (PDA), an ultramobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1700 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region, and a second gate structure extending in the second direction over the second semiconductor region, a first dielectric structure between the first and second semiconductor devices and separating the first gate structure from the second gate structure along the second direction, and a second dielectric structure on the top surface of the first dielectric structure, wherein the second dielectric structure also separates the first gate structure from the second gate structure along the second direction. The first dielectric structure extends along a third direction through a portion of an entire height of the first or second gate structures, and the second dielectric structure extends along the third direction through a remaining portion of the entire height of the first or second gate structures.

Example 2 includes the integrated circuit of Example 1, wherein each of the first and second gate structures have the same height.

Example 3 includes the integrated circuit of Example 1 or 2, wherein a first distance between the first dielectric structure and an edge of the first semiconductor region closest to the first dielectric structure along the second direction is substantially the same as a second distance between the first dielectric structure and an edge of the second semiconductor region closest to the first dielectric structure along the second direction.

Example 4 includes the integrated circuit of any one of Examples 1-3, further comprising spacer structures on sidewalls of the first and second gate structures and extending along the second direction with the first and second gate structures, wherein the first dielectric structure extends beyond the spacer structures along the first direction.

Example 5 includes the integrated circuit of Example 4, wherein the second dielectric structure is seamlessly integrated with the spacer structures.

Example 6 includes the integrated circuit of Example 4 or 5, wherein a top surface of the second dielectric structure is substantially coplanar with a top surface of the spacer structures.

Example 7 includes the integrated circuit of any one of Examples 1-6, wherein the first dielectric structure comprises silicon and nitrogen, and/or the second dielectric structure comprises silicon and nitrogen.

Example 8 includes the integrated circuit of any one of Examples 1-7, wherein the first dielectric structure comprises a dielectric fill and a dielectric liner on the dielectric fill.

Example 9 includes the integrated circuit of Example 8, wherein the dielectric fill comprises a low-k dielectric material and the dielectric liner comprises a high-k dielectric material.

Example 10 includes the integrated circuit of any one of Examples 1-9, wherein a top surface of the first dielectric structure is substantially coplanar with a topmost surface of the first semiconductor region and the second semiconductor region.

Example 11 includes the integrated circuit of any one of Examples 1-10, wherein the first gate structure comprises a first gate electrode on a first gate dielectric and the second gate structure comprises a second gate electrode on a second gate dielectric.

Example 12 includes the integrated circuit of Example 11, wherein the first gate dielectric extends along a first sidewall of the first dielectric structure and a first sidewall of the second dielectric structure, and the second gate dielectric extends along a second sidewall of the first dielectric structure and a second sidewall of the second dielectric structure.

Example 13 includes the integrated circuit of any one of Examples 1-12, wherein the first and second semiconductor regions each comprise a plurality of semiconductor nanoribbons.

Example 14 includes the integrated circuit of Example 13, wherein the plurality of semiconductor nanoribbons comprise germanium, silicon, or a combination thereof.

Example 15 includes the integrated circuit of any one of Examples 1-14, wherein the first dielectric structure is longer than the second dielectric structure along the first direction.

Example 16 is a die that includes the integrated circuit of any one of Examples 1-15.

Example 17 is an electronic device that includes a chip package having one or more dies. At least one of the one or more dies includes a first semiconductor region extending in a first direction from a first source or drain region, a first gate structure extending in a second direction over the first semiconductor region, the second direction being different than the first direction, a second semiconductor region extending in the first direction from a second source or drain region, a second gate structure extending in the second direction over the second semiconductor region, a first dielectric structure separating the first gate structure from the second gate structure along the second direction, and a second dielectric structure on a top surface of the first dielectric structure. The first dielectric structure extends along a third direction through a first portion of an entire height of the first or second gate structure. The second dielectric structure also separates the first gate structure from the second gate structure along the second direction. The second dielectric structure extends along the third direction through a second portion of the entire height of the first or second gate structure. The first and second portions together equal the entire height of the first or second gate structure.

Example 18 includes the electronic device of Example 17, wherein the second dielectric structure comprises silicon and nitrogen.

Example 19 includes the electronic device of Example 17 or 18, wherein a first distance between the first dielectric structure and an edge of the first semiconductor region closest to the first dielectric structure along the second direction is substantially the same as a second distance between the first dielectric structure and an edge of the second semiconductor region closest to the first dielectric structure along the second direction.

Example 20 includes the electronic device of any one of Examples 17-19, further comprising spacer structures on sidewalls of the first and second gate structures and extending along the second direction with the first and second gate structures, wherein the first dielectric structure extends beyond the spacer structures along the first direction.

Example 21 includes the electronic device of Example 20, wherein the second dielectric structure is seamlessly integrated with the spacer structures.

Example 22 includes the electronic device of Example 20 or 21, wherein a top surface of the second dielectric structure is substantially coplanar with a top surface of the spacer structures.

Example 23 includes the electronic device of any one of Examples 17-22, wherein the first dielectric structure comprises silicon and nitrogen.

Example 24 includes the electronic device of any one of Examples 17-23, wherein the first dielectric structure comprises a dielectric fill and a dielectric liner on the dielectric fill.

Example 25 includes the electronic device of Example 24, wherein the dielectric fill comprises a low-k dielectric material and the dielectric liner comprises a high-k dielectric material.

Example 26 includes the electronic device of any one of Examples 17-25, wherein a top surface of the first dielectric structure is substantially coplanar with a topmost surface of the first semiconductor region and the second semiconductor region.

Example 27 includes the electronic device of any one of Examples 17-26, wherein the first gate structure comprises a first gate electrode on a first gate dielectric and the second gate structure comprises a second gate electrode on a second gate dielectric.

Example 28 includes the electronic device of Example 27, wherein the first gate dielectric extends along a first sidewall of the first dielectric structure and a first sidewall of the second dielectric structure, and the second gate dielectric extends along a second sidewall of the first dielectric structure and a second sidewall of the second dielectric structure.

Example 29 includes the electronic device of any one of Examples 17-28, wherein the first and second semiconductor regions each comprise a plurality of semiconductor nanoribbons.

Example 30 includes the electronic device of Example 29, wherein the plurality of semiconductor nanoribbons comprise germanium, silicon, or a combination thereof.

Example 31 includes the electronic device of any one of Examples 17-30, wherein the first dielectric structure is longer than the second dielectric structure along the first direction.

Example 32 includes the electronic device of any one of Examples 17-31, further comprising a printed circuit board, wherein the chip package is coupled to the printed circuit board.

Example 33 is a method of forming an integrated circuit. The method includes forming at least two adjacent fins comprising semiconductor material, the fins extending above a substrate and each extending parallel to one another in a first direction; forming a spacer material over and between the at least two adjacent fins; forming a first dielectric structure on the spacer material between the at least two adjacent fins; recessing the spacer material between the at least two adjacent fins; forming a dielectric fill between the at least two adjacent fins and adjacent to the first dielectric structure; recessing the dielectric fill between the at least two adjacent fins; forming a sacrificial gate extending over the semiconductor material of the at least two adjacent fins and over the first dielectric structure in a second direction different from the first direction; forming a recess through the sacrificial gate over the first dielectric structure; forming spacer structures on sidewalls of the sacrificial gate and within the recess over the first dielectric structure, such that the spacer structures within the recess form a second dielectric structure; removing the sacrificial gate; and forming a gate structure on the semiconductor material of each of the adjacent fins.

Example 34 includes the method of Example 33, wherein the spacer material comprises silicon and oxygen.

Example 35 includes the method of Example 33 or 34, wherein forming the first dielectric structure comprises forming a dielectric liner on the spacer material between the at least two adjacent fins; and forming a dielectric fill on the dielectric liner.

Example 36 includes the method of Example 35, wherein the dielectric fill comprises a low-k dielectric material and the dielectric liner comprises a high-k dielectric material.

Example 37 is an integrated circuit that includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending in the second direction over the second semiconductor region, spacer structures on sidewalls of the first and second gate structures and extending along the second direction with the first and second gate structures, a first dielectric structure separating the first gate structure from the second gate structure along the second direction, and a second dielectric structure on the top surface of the first dielectric structure. The second dielectric structure also separates the first gate structure from the second gate structure along the second direction. The second dielectric structure and the spacer structures are a continuous body of material such that there is no seam between the second dielectric structure and the spacer structures.

Example 38 includes the integrated circuit of Example 37, wherein the second dielectric structure comprises silicon and nitrogen.

Example 39 includes the integrated circuit of Example 37 or 38, wherein a first distance between the first dielectric structure and an edge of the first semiconductor region closest to the first dielectric structure along the second direction is substantially the same as a second distance between the first dielectric structure and an edge of the second semiconductor region closest to the first dielectric structure along the second direction.

Example 40 includes the integrated circuit of any one of Examples 37-39, wherein the first dielectric structure extends along a third direction through a first portion of an entire height of the first and second gate structures, and the second dielectric structure extends along the third direction through a second portion of the entire height of the first and second gate structures, the first and second portions together equaling the entire height of the first and second gate structures.

Example 41 includes the integrated circuit of any one of Examples 37-40, wherein a top surface of the second dielectric structure is substantially coplanar with a top surface of the spacer structures.

Example 42 includes the integrated circuit of any one of Examples 37-41, wherein the first dielectric structure comprises silicon and nitrogen.

Example 43 includes the integrated circuit of any one of Examples 37-42, wherein the first dielectric structure comprises a dielectric fill and a dielectric liner on the dielectric fill.

Example 44 includes the integrated circuit of Example 43, wherein the dielectric fill comprises a low-k dielectric material and the dielectric liner comprises a high-k dielectric material.

Example 45 includes the integrated circuit of any one of Examples 37-44, wherein a top surface of the first dielectric structure is substantially coplanar with a topmost surface of the first semiconductor region and the second semiconductor region.

Example 46 includes the integrated circuit of any one of Examples 37-45, wherein the first gate structure comprises a first gate electrode on a first gate dielectric and the second gate structure comprises a second gate electrode on a second gate dielectric.

Example 47 includes the integrated circuit of Example 46, wherein the first gate dielectric extends along a first sidewall of the first dielectric structure and a first sidewall of the second dielectric structure, and the second gate dielectric extends along a second sidewall of the first dielectric structure and a second sidewall of the second dielectric structure.

Example 48 includes the integrated circuit of any one of Examples 37-47, wherein the first and second semiconductor regions each comprise a plurality of semiconductor nanoribbons.

Example 49 includes the integrated circuit of Example 48, wherein the plurality of semiconductor nanoribbons comprise germanium, silicon, or a combination thereof.

Example 50 includes the integrated circuit of any one of Examples 37-49, wherein the first dielectric structure is longer than the second dielectric structure along the first direction.

Example 51 is a die that includes the integrated circuit of any one of Examples 37-50.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor region extending in a first direction from a first source or drain region, and a first gate structure extending in a second direction over the first semiconductor region, the second direction being different than the first direction;
a second semiconductor device having a second semiconductor region extending in the first direction from a second source or drain region, and a second gate structure extending in the second direction over the second semiconductor region;
a first dielectric structure between the first and second semiconductor devices and separating the first gate structure from the second gate structure along the second direction, the first dielectric structure extending along a third direction through a portion of an entire height of the first or second gate structure; and
a second dielectric structure on a top surface of the first dielectric structure, wherein the second dielectric structure also separates the first gate structure from the second gate structure along the second direction, and wherein the second dielectric structure extends along the third direction through a remaining portion of the entire height of the first or second gate structure.

2. The integrated circuit of claim 1, wherein each of the first and second gate structures have the same height.

3. The integrated circuit of claim 1 or 2, wherein a first distance between the first dielectric structure and an edge of the first semiconductor region closest to the first dielectric structure along the second direction is substantially the same as a second distance between the first dielectric structure and an edge of the second semiconductor region closest to the first dielectric structure along the second direction.

4. The integrated circuit of any one of claims 1 through 3, further comprising spacer structures on sidewalls of the first and second gate structures and extending along the second direction with the first and second gate structures, wherein the first dielectric structure extends beyond the spacer structures along the first direction.

5. The integrated circuit of claim 4, wherein the second dielectric structure is seamlessly integrated with the spacer structures.

6. The integrated circuit of claim 4 or 5, wherein a top surface of the second dielectric structure is substantially coplanar with a top surface of the spacer structures.

7. The integrated circuit of any one of claims 1 through 6, wherein the first dielectric structure comprises silicon and nitrogen, and/or the second dielectric structure comprises silicon and nitrogen.

8. The integrated circuit of any one of claims 1 through 7, wherein the first dielectric structure comprises a dielectric fill and a dielectric liner on the dielectric fill.

9. The integrated circuit of claim 8, wherein the dielectric fill comprises a low-k dielectric material and the dielectric liner comprises a high-k dielectric material.

10. The integrated circuit of any one of claims 1 through 9, wherein a top surface of the first dielectric structure is substantially coplanar with a topmost surface of the first semiconductor region and the second semiconductor region.

11. The integrated circuit of any one of claims 1 through 10, wherein the first gate structure comprises a first gate electrode on a first gate dielectric and the second gate structure comprises a second gate electrode on a second gate dielectric.

12. The integrated circuit of claims 11, wherein the first gate dielectric extends along a first sidewall of the first dielectric structure and a first sidewall of the second dielectric structure, and the second gate dielectric extends along a second sidewall of the first dielectric structure and a second sidewall of the second dielectric structure.

13. The integrated circuit of any one of claims 1 through 12, wherein the first and second semiconductor regions each comprise a plurality of semiconductor nanoribbons.

14. The integrated circuit of claim 13, wherein the plurality of semiconductor nanoribbons comprise germanium, silicon, or a combination thereof.

15. The integrated circuit of any one of claims 1 through 14, wherein the first dielectric structure is longer than the second dielectric structure along the first direction.
